# EUROPÄISCHE PATENTSCHRIFT

(11) **EP 1 171 981 B1**
(45) Veröffentlichungstag und Bekanntmachung des Hinweises auf die Patenterteilung: **05.11.2003**
(21) Anmeldenummer: 00934892.1
(22) Anmeldetag: 11.04.2000
(51) Int. Cl.: H04L 25/03, H04L 27/20, H03M 1/74

(54) **DIGITALES GMSK-FILTER**
DIGITAL GMSK FILTER
FILTRE GMSK NUMERIQUE

(30) Priorität: 22.04.1999 DE 19918388
(43) Veröffentlichungstag der Anmeldung: 16.01.2002
(73) Patentinhaber: Infineon Technologies AG, 81669 München (DE)
(72) Erfinder: KRANZ, Christian, D-40885 Ratingen (DE); CHRIST, Volker, D-41470 Neuss (DE)
(74) Vertreter: Lange, Thomas, Dr.
(86) Internationale Anmeldenummer: DE0001121
(87) Internationale Veröffentlichungsnummer: WO00065789

(56) Entgegenhaltungen:
- EP-A- 0 743 759
- WO-A-97/04525
- WO-A-97/33414

## Beschreibung

Die vorliegende Erfindung betrifft allgemein Modulationssysteme der Frequenzumtastung mit vorgeschaltetem Gaußfilter, sogenannte GMSK-Modulationssysteme. Insbesondere betrifft sie ein verbessertes GMSK-Filter für solche GMSK-Modulationssysteme.

In den heutigen schnurlosen Telefonsystemen oder den Mobilfunksystemen wird häufig die GMSK-Modulation eingesetzt. Bei diesen Modulationssystemen mit vorgeschaltetem Gaußfilter, sogenannten GMSK-Modulationssystemen (Gaussian Minimum Shift Keying-Modulationssystemen) wird ein Trägersignal mit einem gaußgefilterten digitalen Datensignal moduliert. Zur Modulation kann dabei eine Frequenzmodulation (FM-Modulation) oder eine Quadraturmodulation verwendet werden. Da die Quadraturmodulation sehr genau zueinander passende lineare I und Q Pfade und zusätzlich einen Phasenschieber und einen Mischungsbaustein benötigt, ist sie relativ aufwendig zu realisieren. Aus Kostengründen wird daher häufig die einfacher zu implementierende FM-Modulation eingesetzt.

Bei der FM-Modulation wird ein spannungsgesteuerter Oszillator, ein sogenannter VCO (Voltage Controlled Oscillator) verwendet. Das zur Modulation eingesetzte digitale Datensignal wird dazu zunächst mittels eines Gaußfilters gefiltert. Das Gaußfilter sorgt für eine gewisse Glättung der digitalen Rechtecksignale, die das eigentliche Datensignal darstellen. Es stellt gewissermaßen einen Tiefpaß der und sorgt dafür, daß nicht zu abrupte Phasensprünge auftreten. Dadurch kann ein schmalbandigeres moduliertes Trägersignal erreicht werden. Das am Ausgang des Gaußfilters sich ergebende Signal steuert dann den spannungsgesteuerten Oszillator (VCO) an.

Das Gaußfilter kann auf verschiedene Arten verwirklicht werden. Es kann beispielsweise als analoges Filterelement mit diskreten Bauelementen aufgebaut werden, wie das bei den schnurlosen DECT-Telefonen der Firma Siemens verwirklicht wird. Oder es kann als ein digitales Filter ausgebildet werden, wie dies beispielsweise bei den schnurlosen Telefonen der Firmen Phillips und NSC verwirklicht wird.

Bei den bisher üblichen GMSK-Filtern erfolgte eine digitale Vorverarbeitung und anschließend eine Digital-Analog-Umwandlung durch einen X-Bit Digital-Analog-Wandler (D/A-Wandler) . Bei dieser Digital-Analog-Umwandlung gibt es, wie bei jeder Digital-Analog-Umwandlung, durch die Stufenfunktion des D/A-Wandlers zwangsläufig Quantisierungsfehler. Die Quantisierungsfehler können durch ein Verkleinern der im D/A-Wandler auftretenden Stufen vermindert werden, indem dessen Auflösung und damit dessen Bitbreite erhöht werden.

Übliche D/A-Wandler, die nach dem Stromquellenprinzip arbeiten, weisen binär gewichtete Stromquellen auf. Die einzelnen Stromquellen geben hierbei Ströme ab, die ein binäres Vielfaches eines Referenzstromes Iref darstellen. Sie haben also die Größe Iref, 2*Iref, 4*Iref...2^N*Iref. Durch einfaches Addieren kann damit jeder digitale Wert eingestellt werden. Ein Problem bei diesen D/A-Wandlern tritt dadurch auf, daß sich beim Umschalten auf das höchstwertigste Bit (MSB) eine Umschaltung von der Summe aller Referenzströme, außer des größten Referenzstromes, auf den größten Referenzstrom vorgenommen wird. Wenn jetzt die Referenzströme nicht genau abgestimmt sind, was in der Praxis nahezu immer der Fall ist, gibt es einen Sprung in der Wandlerkennlinie. Dadurch können Hochfrequenz-Seitenbandsignale erzeugt werden, die eine vorgeschriebene Seitenbandunterdrückung verletzen.

Bei D/A-Wandlern mit einem Spannungsausgang werden Referenzspannungen addiert. Die Spannungen können aktiv über einen Puffer oder passiv über Widerstände addiert werden. Bei der passiven Version ist aber der Ausgangswiderstand nicht konstant und relativ hochohmig. Außerdem eignen sich widerstände nicht besonders gut für die Integration, da sie viel Fläche für ihre Implementierung benötigen. üblicherweise werden daher die Spannungen über einen Puffer addiert. Dieser muß eine ausreichend hohe Bandbreite (hier in der Größenordnung von 10 MHz) aufweisen. Ein solcher Puffer benötigt aber auch eine relative große Fläche für seine Implementierung und verbraucht viel Strom.

Zusätzlich benötigen die üblichen D/A-Wandler ein digitales Filter. Dieses wird häufig als in einem Festwertspeicher (ROM) abgelegte Tabelle verwirklicht.

Die verwendeten GMSK-Filter sollen im Zuge der immer weitergehenden Miniaturisierung elektronischer Geräte auf minimaler Fläche verwirklicht werden. Gleichzeitig sollen die Filter aber eine möglichst große Genauigkeit aufweisen.

In der internationalen Veröffentlichung WO 97/04525 ist ein digitales GMSK-Filter beschrieben, das durch Summation der Ströme einer Vielzahl einzelner Stromquellen einen Gesamtstrom erzeugt, welcher mittels eines Widerstands in einen entsprechenden Spannungswert umgewandelt wird. Die gemäß der gewünschten Filterfunktion gewichteten Stromquellen werden dabei über ein Schieberegister angesteuert.

In der internationalen Veröffentlichung WO 97/33414 A ist eine Anordnung zur Pulsformung für eine GMSK-Modulation angegeben. Der von der Anordnung empfangene digitale Datenstrom wird mittels Festwertspeichern, Logikschaltungen und einem Digital-Analog-Wandler in ein analoges Steuersignal für einen VCO umgesetzt.

Ein weiterer Digital-zu-Analog-Wandler zur Erzeugung eines GMSK-gewichteten Analogsignals ist in der europäischen Patentanmeldung EP 0 743 759 A1 beschrieben.

Aufgabe der vorliegenden Erfindung ist es, ein GMSK Filter bereitzustellen, das eine möglichst große Genauigkeit aufweist und auf einer minimalen Fläche implementiert werden kann.

Diese Aufgabe wird durch das erfindungsgemäße digitale GMSK-Filter gelöst. Dieses Filter verwendet für den D/A-Wandler einen parallelen D/A-Wandler mit Stromausgang. Das analoge Ausgangssignal besteht dabei aus einem Gesamtstrom, der sich aus der additiven Zusammensetzung von Einzelströmen aus einzelnen Stromquellen ergibt.

Bei den beim erfindungsgemäßen Filter verwendeten Stromquellen handelt es sich um sogenannte Differenzstromquellen. Die Bezeichnung "Differenzstromquelle" soll dabei darauf hinweisen, daß sie jeweils den Strom liefern, der notwendig ist, um von einer Stufe der Wandlerkennlinie auf die nächstes Stufe zu kommen. Die notwendige Chipfläche für die Realisierung des Filters wird dabei nur durch den maximalen Summenstrom bestimmt und nicht durch die Anzahl der Stromquellen.

Die einzelnen Ströme der Differenzstromquellen können in einem externen Widerstand direkt in die für die Ansteuerung des VCO benötigte Steuerspannung umgewandelt werden, so daß im Gegensatz zu den aus dem Stand der Technik bekannten D/A-Wandlern kein Ausgangspuffer notwendig ist.

Die Stromwerte der Differenzstromquellen sind dabei nicht linear sondern gaußförmig gewichtet. Dadurch kann auf eine digitale Filterung verzichtet werden.

Erfindungsgemäß ist das Schieberegister auf beidseitige Eingabemöglichkeit und Umschaltbarkeit der Schieberichtung ausgelegt.

Spannungsgesteuerte Oszillatoren (VCOs) weisen, insbesondere wenn dabei Varaktoren verwendet werden, eine große Streuung ihrer Betriebsparameter auf. Darum muß bei der Produktion die Ansteuerspannung abgeglichen werden, um einen vorbestimmten Frequenzhub des VCO zu erreichen. Dieser Modulationshubabgleich kann beim erfindungsgemäßen GMSK-Filter über eine Abstimmung des Referenzstromes der Differenzstromquellen erfolgen.

Insgesamt verwirklicht das erfindungsgemäße digitale GMSK-Filter ein Filter, das auf einer kleinen Chipfläche implementiert werden kann, die nur durch den maximalen Summenstrom bestimmt wird. Das Filter benötigt keinen Ausgangspuffer. Es wird durch die gaußförmige Gewichtung der Ströme der Differenzstromquellen ein Verzicht auf eine digitale Filterung erreicht. Außerdem kann dadurch eine exakte gaußförmige Wandlerkennlinie verwirklicht werden.

Nachfolgend erfolgt eine detailliertere Erläuterung des erfindungsgemäßen digitalen GMSK-Filters anhand der Zeichnungsfiguren.
Figur 1 zeigt eine schematische Darstellung des erfindungsgemäßen digitalen GMSK-Filters.
Figur 2 zeigt in einer Tabelle die Dimensionierung der Stromquellen und des sich aus der Zusammenschaltung der Stromquellen ergebenden Gesamtstromes.
Figur 3 zeigt ein Ausgangssignal eines GMSK-Modulators, bei dem das erfindungsgemäße GMSK-Filter Anwendung gefunden hat.
Figur 4 zeigt in einer Tabelle, welche Stromquellen beim erfindungsgemäßen GMSK-Filter bei einer Modulationssequenz mit dem Werten 0011 nacheinander geschaltet werden.
Figur 5 zeigt in einer Tabelle, welche Stromquellen beim erfindungsgemäßen GMSK-Filter bei einer Modulationssequenz mit den Werten 00101 nacheinander geschaltet werden.
Figur 6 zeigt in einer Tabelle, das Einstellen der Schieberichtung des Schieberegisters zur Ansteuerung der Stromquellen
Figur 7 zeigt in Tabellenform die Entscheidung für das Durchlaufen der langen Schleife oder der kurzen Schleife des Schieberegisters zur Ansteuerung der Stromquellen.

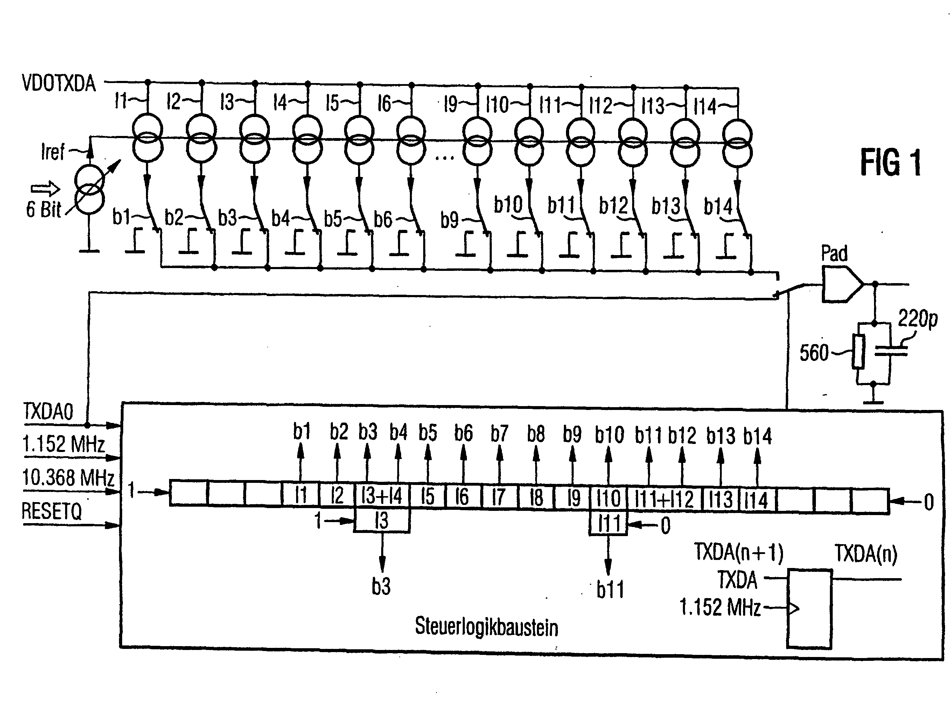

Figur 1 zeigt eine schematische Darstellung des erfindungsgemäßen digitalen GMSK-Filters. Das GMSK-Filter weist in seinem oberen Teil vierzehn einzelne Stromquellen I1 bis I14 auf. Ihre individuellen unterschiedlichen Stromwerte werden mit Hilfe eines Referenzstromes Iref erzeugt. Sie können über insgesamt vierzehn Schalter b1 bis b14 individuell auf eine gemeinsame Leitung geschaltet werden. Die Bezeichnung VDDTXDA bezeichnet dabei die Versorgungsspannung für die Stromquellen.

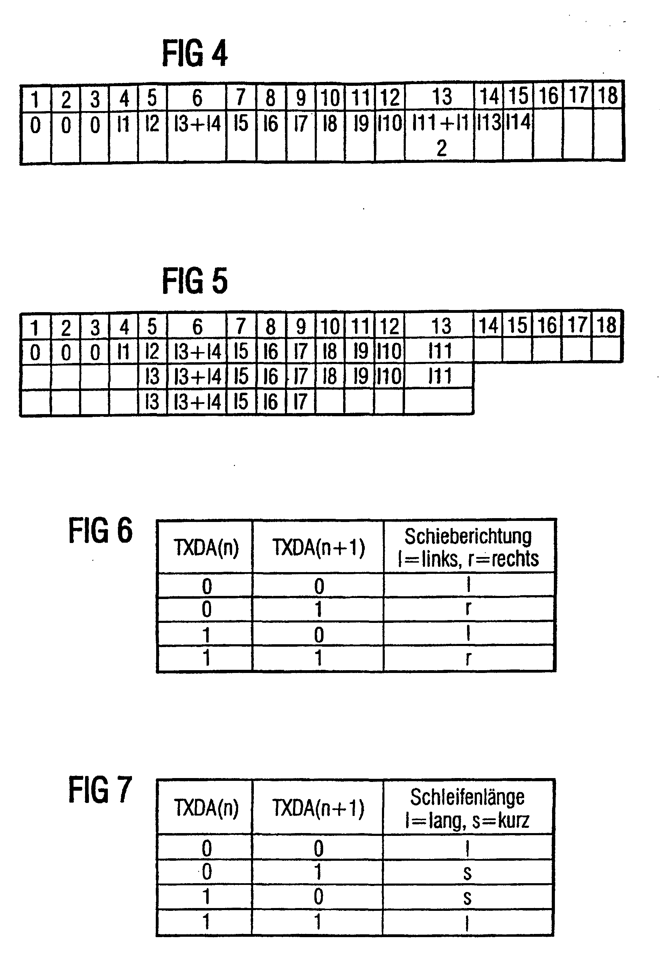

Im unteren Teil ist in Figur 1 der Steuerlogikbaustein für das Schalten der einzelnen Stromquellen gezeigt. Er besteht im wesentlichen aus einem durch die einzelnen Zellen angedeuteten Schieberegister. Die Logik für das Schalten der Stromquellen arbeitet mit einem 18-Bit Thermometer-Code. Dabei wird eine "logische 1" von links und eine "logisch 0" von rechts in das Schieberegister geschoben, was in der Zeichnung durch die "1" an der linken Seite des Schieberegister und die "0" an der rechten Seite des Schieberegister angedeutet ist. Die Schieberichtung ist schaltbar zwischen "Stop", "Links" und "Rechts". Der Schiebetakt beträgt im hier dargestellten Ausführungsbeispiel 10,368 MHz und wird, wie hier an der linken Seite des Logikbausteines dargestellt, von außen dem Steuerlogikbaustein zugeführt. Die genaue Funktion des Schieberegisters wird weiter unten anhand der Figuren 4 und 5 noch näher erläutert. Dem Steuerlogikbaustein werden, wie an der linken Seite des Bausteins angedeutet, unter anderem das Signal TXDAQ, das die zu sendende Bitfolge darstellt, der Takt 1,152 MHz, das ist der Takt, mit dem die zu sendenden Bits ankommen, und der oben schon angegebene Schiebetakt 10,368 MHz zugeführt. Außerdem weist der Steuerlogikbaustein noch einen RESETQ-Eingang auf, mit dem er in einen definierten Ausgangszustand zurückgesetzt werden kann. Im Steuerlogikbaustein ist unter dem Schieberegister noch ein Speicher angedeutet, da man das Signal TXDA sowohl zum Zeitpunkt n als auch zum Zeitpunkt n+1 benötigt.

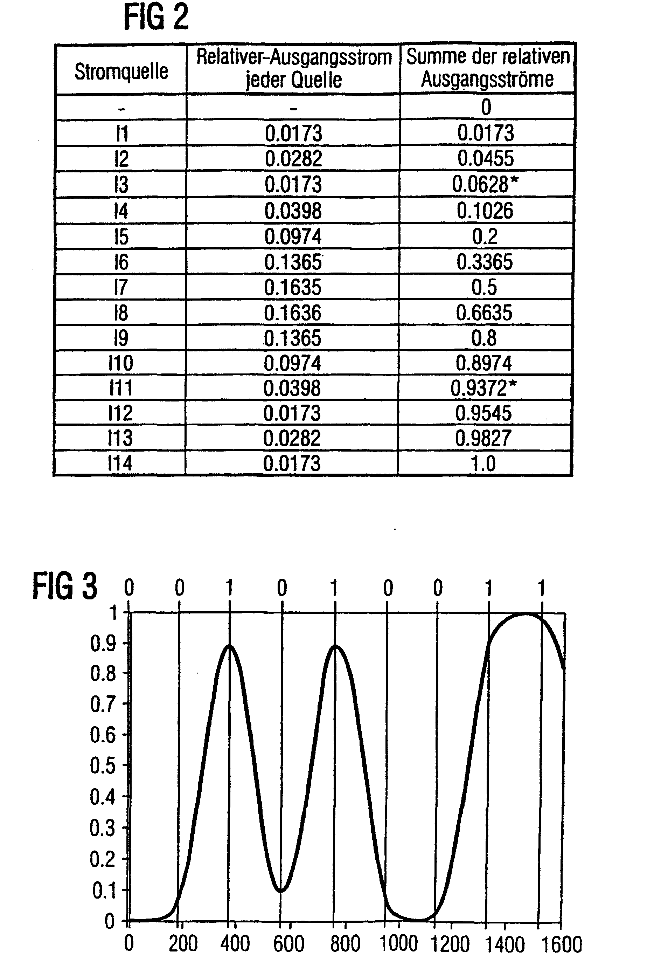

Figur 2 zeigt in einer Tabelle die Dimensionierung der Stromquellen und des sich aus der Zusammenschaltung der Stromquellen ergebenden Gesamtstromes. In der linken Spalte sind die vierzehn hier verwendeten Stromquellen I1 bis I14 aufgeführt. In der mittleren Spalte erkennt man den Stromwert jeder einzelnen Stromquelle. Die Stromwerte der einzelnen Stromquellen werden so gewählt, daß mit ihnen durch wechselnde Zusammenschaltung der Stromquellen möglichst fehlerfrei eine gaußsche Wandlerkennlinie erzielt werden kann. In der rechten Spalte ist der sich aus der sukzessiven Addition der Teilströme der einzelnen Stromquellen ergebenden Gesamtstrom dargestellt. Bei den angegebenen Strömen handelt es sich um relative Werte, das heißt, auf den Gesamtstromwert 1,0 hin normierte Größen.

Figur 3 zeigt ein Ausgangssignal eines GMSK-Modulators, bei dem das erfindungsgemäße GMSK-Filter Anwendung gefunden hat. Am oberen Rand ist ein Beispiel einer Folge binärer Werte, die zur Modulation verwendet werden sollen, angegeben. Es handelt sich hier um die Folge 001010011. Die untere waagrechte Achse ist die Zeitachse und die linke senkrechte Achse gibt den relativen Gesamtstromwert an.

Figur 4 zeigt in einer Tabelle, welche Stromquellen beim erfindungsgemäßen GMSK-Filter bei einer Modulationssequenz mit dem Werten 0011 nacheinander geschaltet werden. Bei einer 0011 Sequenz der binären Modulationswerte wird eine sogenannte lange Schleife des Schieberegister mit dem Thermometer-Code durchlaufen.

Figur 5 zeigt in einer Tabelle, welche Stromquellen beim erfindungsgemäßen GMSK-Filter bei einer Modulationssequenz mit den Werten 00101 nacheinander geschaltet werden. Bei der hier dargestellten 00101 Sequenz wird die sogenannte kurze Schleife des Schieberegisters mit dem Thermometer-Code durchlaufen.

Der im Schieberegister verwendete Code zur Ansteuerung der einzelnen Stromquellen wird Thermometer-Code genannt, da man ihn sich wie ein Thermometer vorstellen kann, bei der die Quecksilbersäule auf und ab läuft. Das heißt, es wird immer nur ein Bit mehr oder ein Bit weniger zu "logisch Eins". Alle niederwertigeren Bits weisen dabei den Pegel "logisch Eins" auf. Das hier verwendete Schieberegister mit dem Thermometer-Code hat eine kurze und eine lange Schleife. Die kurze Schleife wird für 010 oder 101 Bitfolgen durchlaufen, die lange Schleife wird dagegen für 0011 oder 1100 Bitfolgen durchlaufen. Die Entscheidung, ob die kurze oder die lange Schleife durchlaufen wird, wird beim Schalten der Stromquelle 17 durchgeführt. In der langen Schleife wird das Schieberegister immer entweder ganz mit "logischen Einsen" gefüllt, oder es wird ganz geleert, das heißt, vollständig mit "logischen Nullen" gefüllt. In der kurzen Schleife wird die Schieberichtung an Position 5 und Position 13 geändert, und das Schieben für einen Takt unterdrückt. In langen Schleifen kann die Schieberichtung mit jeder steigenden Flanke des Modulationstaktes (hier 1,152 MHz) geändert werden. Die Schieberichtung hängt vom nächsten zu modulierenden Bit ab.

Die Entscheidung für die Schieberichtung ist in Figur 6 nochmals tabellarisch dargestellt.

In Figur 7 ist in Tabellenform die Entscheidung für das Durchlaufen der langen Schleife oder der kurzen Schleife gezeigt.

In beiden Figuren bezeichnet TXDA(n) das Modulationsbit, genauer gesagt den Wert des Modulationsbits, zum Zeitpunkt n, und TXDA(n+1 bezeichnet den Wert des Modulationsbits zum Zeitpunkt n+1.

Insgesamt liefert die vorliegende Erfindung ein digitales GMSK-Filter, bei dem kein getrenntes digitales Filter notwendig ist, da die "Filterung" schon durch die nichtlineare Gewichtung der Stromquellen erreicht wird. Durch die Ansteuerung der Stromquellen über ein Schieberegister mit Thermometer-Code wird immer nur jeweils eine Stromquelle zugeschaltet beziehungsweise abgeschaltet, so daß immer ein monotoner Anstieg beziehungsweise Abfall des Ausgangsstromes erreicht wird. Durch eine individuelle Gewichtung der einzelnen Stromquellen können die Abtastwerte praktisch ohne Quantisierfehler erzielt werden. Es wird kein Ausgangspuffer benötigt, da die Ströme einfach in einem Lastwiderstand addiert werden können.

## Patentansprüche

1. Digitales GMSK-Filter zur Verwendung bei der Frequenzmodulation eines Trägersignals in einem GMSK-Übertragungssystem. welches eine Vielzahl einzelner Stromquellen (I1 bis I14) enthält, die individuelle Stromwerte aufweisen, wobei die Stromquellen einzeln gemäß dem zu modulierenden digitalen Signal über einen Steuerlogikbaustein angesteuert werden, welcher ein Schieberegister umfaßt, in welches die Bits des zu modulierenden digitalen Signals eingeschoben werden, und der Gesamtstrom über einen Ausgangswiderstand (560) in einen Spannungswert umgewandelt wird, der einen spannungsgesteuerten Oszillator steuert, wodurch die Frequenz des Trägersignals moduliert wird,
**dadurch gekennzeichnet,**
**daß**, das Filter derart ausgestaltet ist, daß in das Schieberegister von der einen Seite die Werte "logisch 1" der Modulationsbits und von der entgegengesetzten Seite die Werte "logisch 0" der Modulationsbits eingeschoben werden, und
**daß** die Schieberichtung des Schieberegisters zwischen Stop, Links und Rechts schaltbar ist.

2. Digitales GMSK-Filter nach Anspruch 1, **dadurch gekennzeichnet , daß** die individuellen Stromwerte der einzelnen Stromquellen (I1 bis I14) nichtlinear gewichtet sind.

3. Digitales GMSK-Filter nach Anspruch 2, **dadurch gekennzeichnet, daß** die Wichtung der einzelnen Stromwerte der einzelnen Stromquellen (I1 bis I14) so erfolgt, daß sich als Gesamtstrom durch das jeweilige Hinzuschalten beziehungsweise Abschalten von jeweils einer Stromquelle eine gaußformige Kennlinie ergibt.

4. Digitales GMSK-Filter nach einem der vorhergehenden Ansprüche, **dadurch gekennzeichnet, daß** das Schieberegister eine sogenannte lange Schleife, bei der das Schieberegister immer entweder ganz mit "logischen Einsen" oder ganz mit "logischen Nullen" gefüllt wird, und eine sogenannte kurze Schleife aufweist, bei der die Schieberichtung bei bestimmten Positionen des Schieberegisters geändert und das Schieben für einen Takt unterdrückt wird.

5. Digitales GMSK-Filter nach Anspruch 4, **dadurch gekennzeichnet, daß** bei den langen Schleifen des Schieberegisters die Schieberichtung in Abhängigkeit vom nächsten zu modulierenden Bit geändert wird.

## Claims

1. Digital GMSK filter for use for frequency modulation of a carrier signal in a GMSK transmission system, which contains a large number of individual current sources (I1 to I14) which have individual current values with the current sources individually being driven via a control logic module in accordance with the digital signal to be modulated, which module comprises a shift register into which the bits of the digital signal to be modulated are inserted and with the total current being converted via an output resistor (560) to a voltage value which controls a voltage controlled oscillator, by which means the frequency of the carrier signal is modulated,
**characterized**
**in that** the filter is configured in such a way that the "logic 1" values of the modulation bits are inserted into the shift register from one side, and the "logic 0" values of the modulation bits are inserted from the opposite side, and
**in that** the shift direction of the shift register can be switched between stop, left and right.

2. Digital GMSK filter according to Claim 1, **characterized in that** the individual current values of the individual current sources (I1 to I14) are weighted nonlinearly.

3. Digital GMSK filter according to Claim 2, **characterized in that** the individual current values of the individual current sources (I1 to I14) are weighted such that the total current has a Gaussian characteristic, as a result of the respective connection and disconnection of in each case one current source.

4. Digital GMSK filter according to one of the preceding claims, **characterized in that** the shift register has what is referred to as a long loop, in which the shift register is always filled either entirely with "logic ones" or entirely with "logic zeros", and has what is referred to as a short loop, in which the shift direction for specific positions in the shift register is changed, and the shift process is suppressed for one cycle.

5. Digital GMSK filter according to Claim 4, **characterized in that**, for the long loops in the shift register, the shift direction is changed as a function of the next bit to be modulated.

## Revendications

1. Filtre numérique GMSK destiné à être utilisé dans la modulation de fréquence d'un signal porteur dans un système de transmission GMSK, qui comporte une pluralité de sources (l1 à l14) individuelles de courant, qui ont des valeurs individuelles de courant, les sources de courant étant commandées individuellement suivant le signal numérique à moduler par un module de logique de commande qui comprend un registre à décalage, dans lequel les bits du signal numérique à moduler sont entrés et le courant global est transformé par une résistance (560) de sortie en une valeur de tension qui commande un oscillateur commandé en tension en sorte que la fréquence du signal porteur est modulée,
**caractérisé**
**en ce que** le filtre est constitué de façon à entrer dans le registre à décalage d'un côté des valeurs "1 logique" des bits de modulation et du côté opposé les valeurs "0 logique" des bits de modulation et
**en ce que** la direction de décalage du registre à décalage est commutée entre arrêt, gauche et droite.

2. Filtre GMSK numérique suivant la revendication 1, **caractérisé en ce que** les valeurs individuelles de courant des sources (l1 à l14) individuelles de courant sont pondérées d'une manière qui n'est pas linéaire.

3. Filtre GMSK numérique suivant la revendication 2, **caractérisé en ce que** la pondération des valeurs individuelles de courant des sources (l1 à l14) individuelles de courant s'effectue de façon à obtenir en tant que courant global par l'addition ou la soustraction respective de respectivement une source de courant, une courbe caractéristique de Gauß.

4. Filtre GMSK numérique suivant l'une des revendications précédentes, **caractérisé en ce que** le registre à décalage a ce que l'on appelle une longue boucle, dans laquelle le registre à décalage est empli toujours complètement de "uns logiques" ou complètement de "zéros logiques" et ce que l'on appelle une boucle courte, dans laquelle la direction de décalage est modifiée pour certaines positions du registre de décalage et le décalage est supprimé pour un cycle.

5. Filtre GMSK numérique suivant la revendication 4, **caractérisé en ce que** dans les boucles longues du registre à décalage la direction de décalage est modifiée en fonction du bit immédiatement suivant à modifier.
